(19)

Europäisches Patentamt
European Patent Office
Office européen des brevets

(11) **EP 2 679 385 A1**

(12) **EUROPEAN PATENT APPLICATION**
published in accordance with Art. 153(4) EPC

(43) Date of publication:
**01.01.2014 Bulletin 2014/01**

(21) Application number: **12748876.5**

(22) Date of filing: **22.02.2012**

(51) Int Cl.:
**B32B 27/00** (2006.01)   **B32B 27/30** (2006.01)
**B32B 27/32** (2006.01)

(86) International application number:
**PCT/JP2012/054223**

(87) International publication number:
**WO 2012/115132 (30.08.2012 Gazette 2012/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2011   JP 2011038042**
**26.08.2011   JP 2011184394**

(71) Applicant: **Toray Industries, Inc.**
**Tokyo, 103-8666 (JP)**

(72) Inventors:
• **KURASEKO, Emi**
  **Shiga 520-8558 (JP)**
• **TAKADA, Susumu**
  **Shiga 520-8558 (JP)**
• **SUZUKI, Motoyuki**
  **Shiga 520-8558 (JP)**

(74) Representative: **Kador & Partner**
**Corneliusstrasse 15**
**80469 München (DE)**

(54) **TRANSFER FILM**

(57) Disclosed is a transfer film comprising a support film and a transfer layer having a thickness of 0.01 to 10 μm laminated on the support film, wherein the transfer layer contains a siloxane oligomer and the content of silicon atoms relative to the total numbers of carbon, oxygen and silicon atoms as measured by X-ray photoelectron spectroscopy of the transfer layer is from 5 to 33%. The present invention provides a transfer film for applying a transfer layer to a transfer-receiving material with a large area by a simple production process without any defects.

Fig. 8

(a)

8

6

(b)

8

7

6

**Description**

[Technical Field]

The present invention relates to a transfer film for transferring a layer made of siloxane onto a transfer-receiving material with a large area.

[Background Art]

Various substrates such as a glass substrate, a metal substrate and a crystal substrate have recently been used as a semiconductor substrate which is used in liquid crystal displays, solar batteries and LEDs. There is a need to form function layers having various functions, such as antistatic, antireflection, antifouling, light scattering, power generating and light emitting layers, which are required for the respective applications on surfaces of these substrates. There has hitherto been known, as a method for formation of a function layer, a method in which a photocurable resin is coated on a base material. However, a layer formed of the photocurable resin had a problem in that the layer cannot be processed at high temperature because of the occurrence of decomposition at high temperature higher than 250°C or yellowing due to ultraviolet rays, and heat resistance and light resistance during use cannot be obtained.

To the contrary, siloxane does not cause decomposition at high temperature or yellowing as compared with the photocurable resin, and thus enabling use or processing at high temperature. There has been known, as a method for formation of a layer made of siloxane, a sol-gel method in which a solution containing a silicon alkoxide is coated on a base material, followed by heating to obtain a layer made of siloxane (Patent Literature 1). In these methods, there is also known a method in which fine shape is imparted to the surface of a function layer to be formed. For example, there is known a method in which a solution containing a silicon alkoxide is coated on a base material, followed by pressing of a mold and further solidification (Patent Literature 2) or a method in which a pattern is formed by a resist using a resin having a siloxane structure imparted with ultraviolet curability (Patent Literature 3).

[Citation List]

[Patent Literature]

[Patent Literature 1]
Japanese Patent No. 4079383
[Patent Literature 2]
Japanese Patent No. 3750393
[Patent Literature 3]
Japanese Unexamined Patent Publication (Kokai) No. 2006-154037

[Summary of Invention]

[Technical Problem]

However, when a layer made of siloxane is formed by the sol-gel method, it was difficult to continuously form a uniform film on a rigid material such as glass or to form a uniform layer on a curved surface. There was also a problem that stable quality is less likely to be obtained since defects due to gelation are likely to be generated in a solution containing a silicon alkoxide. There was also a problem that a large amount of a solvent must be removed and recovered for drying and solidification of a sol solution, and thus need an environmentally friendly large-sized facility during processing.

Furthermore, if an attempt is made to impart a fine shape to the surface of a siloxane layer so as to obtain optical properties or surface properties, there was a limitation on the range of applications because of a need of the process which is complicated and has low productivity, for example, a solution containing a silicon alkoxide is coated and then a mold is pressed immediately before gelation, followed by heating for a long time.

An object of the present invention is to provide a transfer film for applying a low-defect layer made of siloxane to a transfer-receiving material with a large area by a simple production process such as lamination. Another object of the present invention is to provide a transfer film for applying a layer made of siloxane imparted with any fine shape to the surface by a similar process.

[Solution to Problem]

The transfer film of the present invention is a transfer film comprising a support film and a transfer layer having a thickness of 0.01 to 10 $\mu$m laminated on the support film, wherein the transfer layer contains a siloxane oligomer and the content of silicon atoms relative to the total numbers of carbon, oxygen and silicon atoms as measured by X-ray photoelectron spectroscopy of the transfer layer is from 5 to 33%.

[Advantageous Effects of Invention]

According to the present invention, it is possible to apply a low-defect siloxane layer, which is excellent in heat resistance and light resistance, to a transfer-receiving material with a large area by a simple production process. In particular, when the surface of the support film, which comes into contact with the transfer layer, has a concave-convex shape, it is possible to apply a siloxane layer with the surface having a fine concave-convex shape to a transfer-receiving material with a large area by a simple production process without the occurrence of cracking.

[Brief Description of Drawings]

Fig. 1 is a schematic view illustrating manual three-measurement point selection position of liquid droplets in the measurement of a contact angle.
Fig. 2 is a schematic view illustrating the thickness of a transfer layer of a support film having a concave-convex shape.
Fig. 3 is an adhesion force test sample in which a stud pin on a three-layered laminate of transfer-receiving material/ transfer layer/support film is fixed by a mounting clip, in which Fig. 3(a) is a schematic view as viewed from the side, while Fig. 3(b) is a schematic view as viewed from the bonding side of the stud pin.
Fig. 4 is a schematic view as viewed from the side of a sample for the measurement of an adhesion force in which a stud pin is fixed to a three-layered laminate of transfer-receiving material/transfer layer/support film.
Fig. 5 is a schematic view illustrating a state where an adhesion force test sample is fixed to a measuring apparatus, in which Fig. 5(a) is a schematic view as view from the side, while Fig. 5(b) is a schematic view as viewed from the bonding side of the stud pin.
Fig. 6 is a load-indentation depth diagram obtainable by a nanoindentation method.
Fig. 7 is a hardness-indentation depth diagram obtainable by a continuous stiffness measurement method.
Fig. 8 (a) is a schematic cross-sectional view of a transfer film in which a support film is flat, while Fig. 8 (b) is a schematic cross-sectional view of a transfer film for forming a transfer layer having a concave-convex shape by preliminarily imparting a concave-convex shape to the surface of a support film, which comes into contact with a transfer layer.
Fig. 9 (a) is a schematic cross-sectional view of a transfer film having a concave-convex shape at the interface between a support film and a transfer, while Fig. 9(b) is a schematic cross-sectional view of a transfer film in which protrusions of a transfer layer, having a concave-convex shape formed at the interface between a support film and a transfer layer, are flat.

[Description of Embodiments]

The transfer film of the present invention and the method for producing the same will be described in more detail below with reference to the accompanying drawings.
The transfer film of the present invention is a transfer film comprising a support film and a transfer layer having a thickness of 0.01 to 10 $\mu$m laminated on the support film, wherein the transfer layer contains a siloxane oligomer and the content of silicon atoms relative to the total numbers of carbon, oxygen and silicon atoms as measured by X-ray photoelectron spectroscopy (XPS) of the transfer layer is from 5 to 33%.

[Support]

The support is preferably a film having a thickness of 5 to 500 $\mu$m, and more preferably a thickness of 40 to 300 $\mu$m. When the thickness of the film is less than 5 $\mu$m, the support may sometimes be twisted in the case of transferring a transfer layer, and thus fail to accurately coat a transfer-receiving material. On the other hand, when the thickness of the film is more than 500 $\mu$m, support film may sometimes become rigid, and thus fail to conform to a coated material. There is no particular limitation on the material of the support film, as long as it can endure removal of the solvent of the transfer layer or heating in the case of transfer to the coated material. It is possible to use, for example, polyester-based resins such as polyethylene terephthalate, polyethylene-2,6-naphthalate, polypropylene terephthalate, and polybutylene terephthalate; polyolefin-based resins such as polyethylene, polystyrene, polypropylene, polyisobutylene, polybutene, and polymethylpentene; cyclic polyolefin-based resins; polyamide-based resins; polyimide-based resins; polyether-based resins; polyesteramide-based resins; polyetherester-based resins; acrylic resins; polyurethane-based resins; polycarbonate-based resins; or polyvinyl chloride-based resins. From the viewpoint of being capable of reconciling coatability of a siloxane sol which is a raw material of the transfer layer, and mold releasability between the transfer layer and the support film, polyolefin-based resins or acrylic resins are preferable.

It is also possible to use, as the support film, a laminated film composed of different resin layers so as to cause the surface of the support film to be in an appropriate state. When the support film is a laminated film, the surface of the support film, whereon the transfer layer is laminated, is preferably made of the above-mentioned resins. Furthermore, the surface of these support films, which comes into contact with the transfer layer, may be subjected to a treatment for coating a backing conditioner or a primer, or a silicone-based or fluorine-based mold release coating agent so as to impart coatability or mold releasability, or the surface may be subjected to a sputtering treatment using noble metal such as gold or platinum.

In the support film, surface free energy of the surface, whereon a transfer layer is laminated, is preferably from 23 to 70 mN/m, and more preferably from 25 to 60 mN/m. When the surface free energy is lower than 23 mN/m, cissing may occur during coating because of poor wettability of the surface of the support film, failing to form a film without any defects. When the surface free energy is higher than 70 mN/m, the adhesion force between the support film and the transfer layer may increase, while mold releasability may deteriorate, leading to loss of a function as the transfer film.

As used herein, the surface free energy is represented by sum of values of a dispersion force component, a polar force component, and a hydrogen bond component. The surf ace free energy of a target surface to be measured can be calculated by the following procedure. With respect to four kinds of liquids, surface free energy and each component (a dispersion force component, a polar force component, a hydrogen bond component) of which are known, a contact angle with the target surface to be measured is measured, followed by substitution of the value of each component of the liquid and the value of the obtained contact angle in the following equation derived from the extended Fowkes equation and the Young's equation, and further solving of simultaneous equations:

$$(\gamma_s^d \cdot \gamma_L^d)^{1/2} + (\gamma_s^p \cdot \gamma_L^p)^{1/2} + (\gamma_s^h \cdot \gamma_L^h)^{1/2} = (1 + \cos\theta)/2$$

where $\gamma_L^d$, $\gamma_L^p$ and $\gamma_L^h$ respectively denote values (known) of a dispersion force component, a polar force component and a hydrogen bond component of a measuring liquid; $\theta$ denotes a contact angle of a measuring liquid on a measuring surface; and $\gamma_s^d$, $\gamma_s^p$ and $\gamma_s^h$ respectively denote values of a dispersion force component, a polar force component and a hydrogen bond component of the measuring surface. Pure water, ethylene glycol, formamide and methylene iodide are used as four kinds of liquids, surface free energy and each component of which are known. The values of each component are shown in Table 1.

[Table 1]

| | Surface energy of each solvent (mN/m) | | | |
|---|---|---|---|---|
| | Dispersion force component | Polar force component | Hydrogen bond component | Total (surface free energy) |
| Pure water | 10.8 | 22.74 | 38.46 | 72 |
| Ethylene glycol | 17.5 | 4.69 | 25.96 | 48.15 |
| Formamide | 18.1 | 26.34 | 13.9 | 58.34 |
| Methylene chloride | 43.7 | 1.31 | 2.65 | 47.66 |

In the measurement of surface free energy in the present invention, an influence of measurement environment on surface free energy is removed in the following manner. Namely, with respect to a measurement sample and a standard sample, the measurement of a contact angle and the calculation of surface free energy from the measured data were performed to obtain the respective found data. Then, based on a difference between the found data and the standard value of the standard sample, the found data of the measurement sample is corrected, thereby offsetting the influence of measurement environment on surface free energy. Specific procedure is as follows: (i) measurement of a contact angle and calculation of surface free energy of the measurement sample, (ii) measurement of a contact angle and calculation of surface free energy of the standard sample, and (iii) correction of data obtained in (i) using the value obtained in (ii) and the standard value of the standard sample are carried out in this order.

(I) Measurement of Contact Angle and Calculation of Surface Free Energy of Measurement Sample

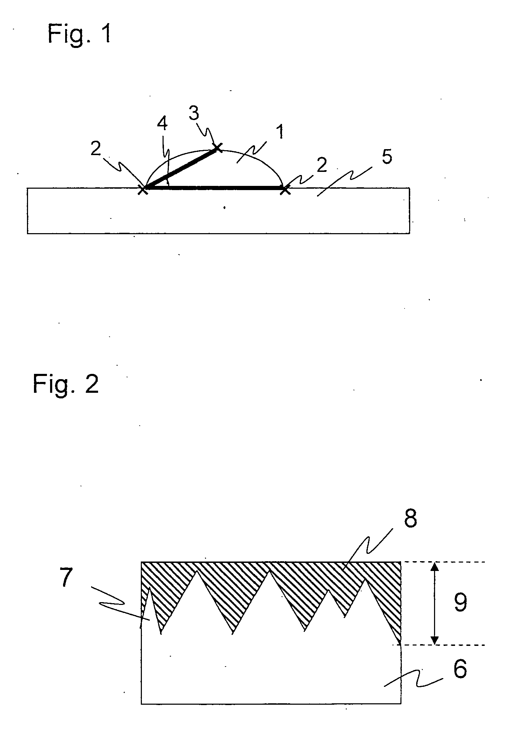

The measurement of a contact angle for the calculation of surface free energy is performed by manual measurement at 3 measurement points in accordance with a liquid drop method ($\theta$/2 method) using Contact Angle Meter, Model CA-X, manufactured by Kyowa Interface Science Co., Ltd. First, a measurement sample is set on a sample stage so as to give a level surface. Using pure water as a measuring liquid, 0.4 $\mu$L of a liquid droplet of pure water is adhered on a measuring surface of the measuring sample by a syringe. Five seconds after adhesion, liquid droplet images are allowed to undergo freezing and a contact angle of the liquid droplet is measured. Since the contact angle is determined by manual measurement at 3 measurement points, points 2 of both ends and then vertex 3 of a liquid droplet 1 of a sample 5 as shown in Fig. 1 are selected and $\theta$/2 (4) of the liquid droplet is calculated and the value, which is twice $\theta$/2, is defined as a contact angle. The measurement is repeated five times, and the average value is defined as a value of a contact angle of the measurement sample. However, when stains or scratches exist on the measuring surface, it is impossible to obtain an accurate value. Therefore, when the standard deviation of contact angles obtained by measuring five times is more than 3.0, the measurement shall be performed again. Also with respect to three kinds of measuring liquids such as ethylene glycol, formamide and methylene iodide, the contact angle is measured in the same manner as in the case of measuring using pure water. Found values ($[\gamma_s^d]$ SE, $[\gamma_s^p]$SE, $[\gamma_s^h]$SE) of each component of each component of surface free energy are calculated, after substitution of measured values of the contact angle value of the above four kinds of liquids in the above-mentioned equation.

(ii) Measurement of Contact Angle and Calculation of Surface Free Energy of Standard Sample

A surface of a 100 $\mu$m thick polyester film "Lumilar (registered trademark) ", Model No. U426, manufactured by Toray Industries, Inc. was used as a standard sample for correction. With respect to the surface of the standard sample for correction, contact angles of four kinds of measuring liquids such a pure water, ethylene glycol, formamide and methylene iodide were measured under the same temperature and humidity environment as in (i) by the same procedure as in (i), and then found values ($[\gamma_s^d]$RE, $[\gamma_s^p]$RE, $[\gamma_s^h]$RE) of each component of surface free energy are calculated.

(iii) Correction of Found Values of Each Component of Surface Free Energy

A standard value of a dispersion force component ($[\gamma_s^d]$RT), a standard value of a polar force component ($[\gamma_s^p]$RT), and a standard value of a hydrogen bond component ($[\gamma_s^h]$RT) of the surface of a 100 $\mu$m thick polyester film "Lumilar (registered trademark)", Model No. U426, manufactured by Toray Industries, Inc., which is a sample for correction, are respectively 27.1 mN/m, 10.8 mN/m, and 7.0 mN/m. Therefore, the found values ($[\gamma_s^d]$SE, $[\gamma_s^p]$SE, $[\gamma_s^h]$SE) determined by (i) are corrected by the following equations using these values to obtain each component value ($[\gamma_s^d]$ST, $[\gamma_s^p]$ST, $[\gamma_s^h]$ST) of the measurement samples.

$$[\gamma_s^d]ST = [\gamma_s^d]SE - ([\gamma_s^d]RE - [\gamma_s^d]RT)$$

$$[\gamma_s^p]ST = [\gamma_s^p]SE - ([\gamma_s^p]RE - [\gamma_s^p]RT)$$

$$[\gamma_s^h]ST = [\gamma_s^h]SE - ([\gamma_s^h]RE - [\gamma_s^h]RT)$$

In the present invention, standard values ($[\gamma_s^d]$RT, $[\gamma_s^p]$RT, $[\gamma_s^h]$RT) of each component of standard samples used herein are values determined by measuring under three environments such as room temperature of 30°C and humidity of 35%, room temperature of 23°C and humidity of 32%, and room temperature of 24°C and humidity of 28%, using standard samples, followed by determination of the average value of values of each component of surface free energy obtained by calculating using the method (i).

[Composition of Transfer Layer]

In the transfer film of the present invention, the transfer layer laminated on the support film contains a siloxane oligomer. While individual component of the transfer layer will be described in detail below, the content of silicon atoms relative to the total numbers of carbon, oxygen and silicon atoms as measured by X-ray photoelectron spectroscopy (XPS) of the transfer layer (hereinafter sometimes simply referred to as the content of silicone atoms) is preferably from 5 to 33%, and more preferably from 8 to 30%. When the content of silicone atoms is less than 5%, the obtained structure may have fewer siloxane bonds in the siloxane oligomer contained in transfer layer and has high organic substance content, and thus causing decomposition at high temperature or yellowing due to ultraviolet rays in the transfer layer. When the content of silicone atoms is more than 33%, the structure of the siloxane oligomer contained in the transfer layer may become significantly similar to that of glass, leading to deterioration of adhesion to a transfer-receiving material. The content of the siloxane oligomer in the transfer layer is preferably from 50 to 99% by mass.

[Siloxane Oligomer]

As mentioned above, the siloxane oligomer is contained in the transfer layer. As used herein, the siloxane oligomer means a siloxane compound which includes a polyorganosiloxane skeleton having two or more continuous siloxane bonds in the structure. The siloxane oligomer may also partially include, as a partial structure, a silica structure which does not have an organic functional group bonded directly to silicone atoms. There is no particular limitation on the weight average molecular weight of the siloxane oligomer, and it is preferably from 500 to 100, 000 in terms of polystyrene-equivalent weight average molecular weight measured by GPC. The siloxane oligomer is synthesized by solidification of a siloxane sol, which is synthesized by a hydrolysis and polycondensation reaction of one or more kinds of organosilanes represented by the general formula (1) shown below, through heating under pressure:
$$(R1)_n\text{-}Si\text{-}(OR2)_{4-n} \qquad (1)$$

wherein R1 represents any one of hydrogen, an alkyl group having 1 to 10 carbon atoms, an alkenyl group having 2 to 10 carbon atoms and an aryl group having 6 to 15 carbon atoms, and a plurality of R1(s) may be the same or different; R2 represents any one of hydrogen, an alkyl group having 1 to 6 carbon atoms, an acyl group having 1 to 6 carbon atoms and an aryl group having 6 to 15 carbon atoms, and a plurality of R2(s) may be the same or different; and n represents an integer of from 0 to 3.

From the viewpoint of prevention of the occurrence of cracking during a storage period of a transfer film or prevention of the occurrence of cracking in a heat treatment of a transfer article, the siloxane oligomer is preferably a siloxane oligomer obtained by polymerizing a monomer containing 5 to 100 mol% of an organosilane in which n is from 1 to 3 in the general formula (1).

In the organosilane represented by the general formula (1), an alkyl group, an alkenyl group or an aryl group represented by R1 may be non-substituted or substituted group, and selection can be made depending on properties of the composition. Specific examples of the alkyl group include a methyl group, an ethyl group, an n-propyl group, an isopropyl group, an n-butyl group, a t-butyl group, an n-hexyl group, an n-decyl group, a trifluoromethyl group, a 3,3,3-trifluoropropyl group, a 3-glycidoxypropyl group, a 2-(3,4-epoxycyclohexyl)ethyl group, a [(3-ethyl-3-oxetanyl)methoxy] propyl group, a 3-aminopropyl group, a 3-mercaptopropyl group, and a 3-isocyanatepropyl group. Specific examples of the alkenyl group include a vinyl group, a 3-acryloxypropyl group, and a 3-methacryloxypropyl group. Specific examples of the aryl group include a phenyl group, a tolyl group, a p-hydroxyphenyl group, a 1-(p-hydroxyphenyl)ethyl group, a 2-(p-hydroxyphenyl)ethyl group, a 4-hydroxy-5-(p-hydroxyphenylcarbonyloxy)pentyl group, and a naphthyl group.

In the organosilane represented by the general formula (1), an alkyl group, an acyl group or an aryl group represented by R2 may be non-substituted or substituted group, and selection can be made depending on properties of the composition. Specific examples of the alkyl group include a methyl group, an ethyl group, an n-propyl group, an isopropyl group, an n-butyl group, an n-pentyl group, and an n-hexyl group. Specific examples of the acyl group include an acetyl group, a propinoyl group, a butyroyl group, a pentanoyl group, and a hexanoyl group. Specific examples of the aryl group include a phenyl group and a naphthyl group.

n in the general formula (1) represents an integer of from 0 to 3. The organosilane is a tetrafunctional silane when n = 0, a trifunctional silane when n = 1, a difunctional silane when n = 2, or a monofunctional silane when n = 3.

Specific examples of the organosilane represented by the general formula (1) include tetrafunctional silanes such as tetramethoxysilane, tetraethoxysilane, tetraacetoxysilane, and tetraphenoxysilane; trifunctional silanes such as methyltrimethoxysilane, methyltriethoxysilane, methyltriisopropoxysilane, methyl tri-n-butoxysilane, ethyltrimethoxysilane, ethyltriethoxysilane, ethyltriisopropoxysilane, ethyl tri-n-butoxysilane, n-propyltrimethoxysilane, n-propyltriethoxysilane, n-butyltrimethoxysilane, n-butyltriethoxysilane, n-hexyltrimethoxysilane, n-hexyltriethoxysilane, decyltrimethoxysilane, vinyltrimethoxysilane, vinyltriethoxysilane, 3-methacryloxypropyltrimethoxysilane, 3-methacryloxypropyltriethoxysilane, 3-acryloxypropyltrimethoxysilane, phenyltrimethoxysilane, phenyltriethoxysilane, trifluoromethyltrimethoxysilane, trifluoromethyltriethoxysilane, 3,3,3-trifluoropropyltrimethoxysilane, 3-aminopropyltrimethoxysilane, 3-aminopropyltriethoxysilane, 3-glycidoxypropyltrimethoxysilane, 3-glycidoxypropyltriethoxysilane, 2-(3,4-epoxycyclohexyl) ethyltrimethoxysilane, and 3-mercaptopropyltriethoxysilane; difunctional silanes such as dimethyldimethoxysilane, dimethyldiethoxysilane, dimethyldiacetoxysilane, di-n-butyldimethoxysilane, and diphenyldimethoxysilane; and monofunctional silanes such as trimethylmethoxysilane and tri-n-butylethoxysilane.

These organosilanes may be used alone, or two or more kinds of organosilanes may be used in combination. From the viewpoint of prevention of cracking of a concave-convex layer after curing, and flexibility of a transfer film, trifunctional silanes and difunctional silanes are preferably used in combination. Silica particles may also be added in the transfer layer so as to improve abrasion resistance or hardness.

The transfer layer may contain therein, in addition to the siloxane oligomer, releasants or leveling agents for improving mold releasability to a support film or wettability, and acrylic resins for improving adhesion to a resin-based transfer-receiving material or cracking resistance.

[Lamination of Transfer Layer]

A method of laminating a transfer layer on a support film is preferably a method in which a siloxane sol diluted with a solvent is coated on a support film and then dried, since it is easy to adjust the film thickness and an adverse influence is scarcely exerted by the thickness of the support film.

There is no particular limitation on the solvent used to dilute a siloxane sol, as long as it has solubility which enables preparation of a siloxane sol solution having the concentration suited for coating. An organic solvent is preferable in view of the fact that cissing is less likely to occur on the film. Examples thereof include high boiling point alcohols such as 3-methyl-3-methoxy-1-butanol; glycols such as ethylene glycol and propylene glycol; ethers such as ethylene glycol monomethyl ether, ethylene glycol monomethyl ether acetate, propylene glycol monomethyl ether, propylene glycol monoethyl ether, propylene glycol monomethyl ether acetate, propylene glycolmonoethyl ether, propylene glycol monopropyl ether, propylene glycol monobutyl ether, diethyl ether, diisopropyl ether, di-n-butyl ether, diphenyl ether, diethylene glycol dimethyl ether, diethylene glycol diethyl ether, diethylene glycol ethyl methyl ether, and dipropylene glycol dimethyl ether; ketones such as methyl isobutyl ketone, diisopropyl ketone, diisobutyl ketone, cyclopentanone, cyclohexanone, 2-heptanone, and 3-heptanone; amides such as dimethylformamide and dimethylacetamide; esters such as ethyl acetate, butyl acetate, ethyl acetate, ethyl cellosolve acetate, and 3-methyl-3-methoxy-1-butanol acetate; aromatic or aliphatic hydrocarbons, such as toluene, xylene, hexane, cyclohexane, mesitylene, and diisopropylbenzene; $\gamma$-butyrolactone, N-methyl-2-pyrrolidone, and dimethyl sulfoxide. In view of solubility and coatability of the siloxane oligomer, preferable solvents are selected from propylene glycol monomethyl ether, propylene glycol monoethyl ether, propylene glycol monomethyl ether acetate, propylene glycol monoethyl ether, diisobutyl ether, di-n-butyl ether, diethylene glycol dimethyl ether, diethylene glycol diethyl ether, diethylene glycol ethyl methyl ether, dipropylene glycol dimethyl ether, methyl isobutyl ketone, diisobutyl ketone, and butyl acetate.

The method of coating a siloxane sol may be, for example, a coating method selected appropriately from gravure coating, roll coating, spin coating, reverse coating, bar coating, screen coating, blade coating, air knife coating, and dip coating methods, and the selected method may be applied.

After coating, the support film coated with the siloxane sol is dried by heating or under reduced pressure. In the case of drying with heating, the heating temperature is preferably 20°C or higher and 180°C or lower. When the heating temperature is lower than 20°C, drying may need a long time. On the other hand, when heated to the temperature higher than 180°C, polymerization of the siloxane due to heating may lead to loss of flexibility of the transfer film to cause cracking or deterioration of transferability to the transfer-receiving material. In the case of drying under reduced pressure, pressure reduction conditions may be appropriately set as long as shape collapse of the transfer film does not occur. It is preferred to reduce the pressure to 0.1 atm. Drying may also be performed by heating together with pressure reduction. In such a manner, even after heating the transfer film at 80°C for 1 hour, the transfer film is dried until a change in thickness of the transfer layer does not occur. Specifically, there is exemplifiedamethod in which heating is performed at 80°C for 5 minutes after being left to stand under reduced pressure of 0.1 atm for 5 minutes.

[Thickness of Transfer Layer]

The thickness of the transfer layer is preferably from 0.01 to 10 $\mu$m, and more preferably from 0.1 to 5 $\mu$m. A transfer layer having a thickness of less than 0.01 $\mu$m is prone to cissing during coating of a siloxane sol, and may result in the formation of defects on the transfer layer. A transfer layer having a thickness of more than 10 $\mu$m, on the other hand, may cause cracking on the transfer layer due to film stress during its hardening. Herein, the thickness of a transfer layer means the thickness of a transfer layer in a transfer layer, and it goes without saying that the thickness of a transfer layer is a thickness after drying in the above-mentioned step of laminating the transfer layer. The thickness of a transfer layer is measured by cutting a transfer film on a microtome and taking an image of the cross-section of the transfer film by a scanning electron microscope (hereinafter sometimes abbreviated to SEM).

When the transfer layer is flat, the thickness of the transfer layer is determined by measuring the thickness of the transfer layer at four positions where a cross-sectional image of the transfer layer taken by SEM is divided equally into five parts in a direction perpendicular to the thickness direction, and averaging the four thicknesses.

When the surface of the transfer layer and/or the interfacial surface between the transfer layer and the support film have/has a concave-convex shape (which cases are collectively referred to as cases where the transfer layer has a concave-convex shape), on the other hand, the thickness of the transfer layer is defined as the thickness at a portion where the transfer layer has the maximum thickness in its cross-sectional image taken by SEM. For example, as described with reference to Fig. 2, when the transfer film on its SEM image is horizontally placed in a state where the surface of the support film facing away from the transfer layer is faced downward, the distance between the lowest position in the recesses on the interfacial surface between the support film 6 and the transfer layer 8, and the outermost surface of the transfer layer is defined as the thickness 9 of the transfer layer.

The magnification for observation and measurement by SEM is 50,000 times for transfer layers having a thickness of 0.001 to 0.01 $\mu$m, 20,000 times for transfer layers having a thickness of 0.01 to 2 $\mu$m, 5,000 times for transfer layers having a thickness of 2 to 5 $\mu$m, and 2, 500 times for transfer layers having a thickness of 5 to 10 $\mu$m.

[Adhesion Force at Interface between Support Film and Transfer Layer]

The adhesion force at the interface between the support film and the transfer layer (hereinafter sometimes simply referred to as an adhesion force) is preferably 0.02 MPa to 1.50 MPa. A transfer film having an adhesion force of less than 0.02 MPa may cause delamination between the support film and the transfer layer, whereby such a transfer film cannot be handled as transfer film and cannot be practically subjected to operations of transferring onto a transfer-receiving material. A transfer film having an adhesion force of more than 1.50 MPa, on the other hand, may cause the transfer layer not to be detached from the support film, whereby the transfer layer cannot be transferred onto a transfer-receiving material.

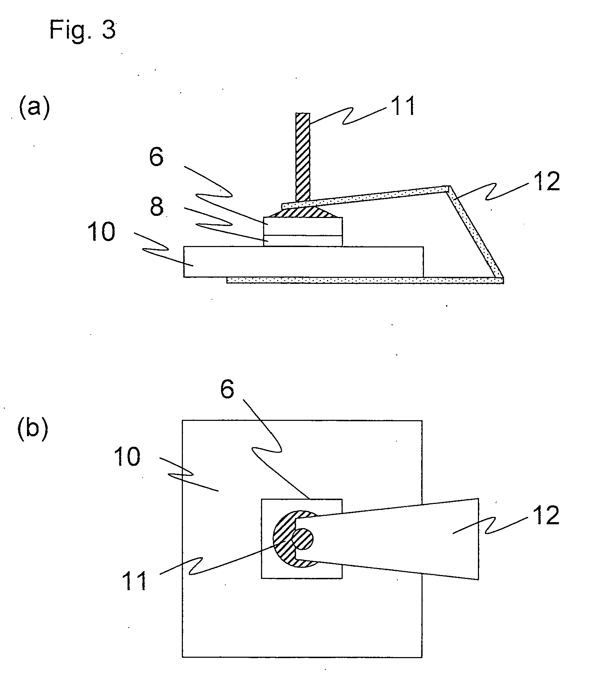

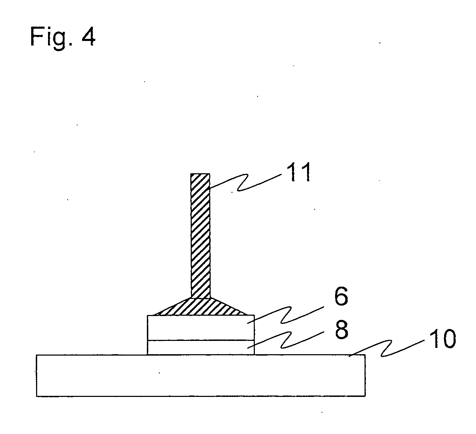

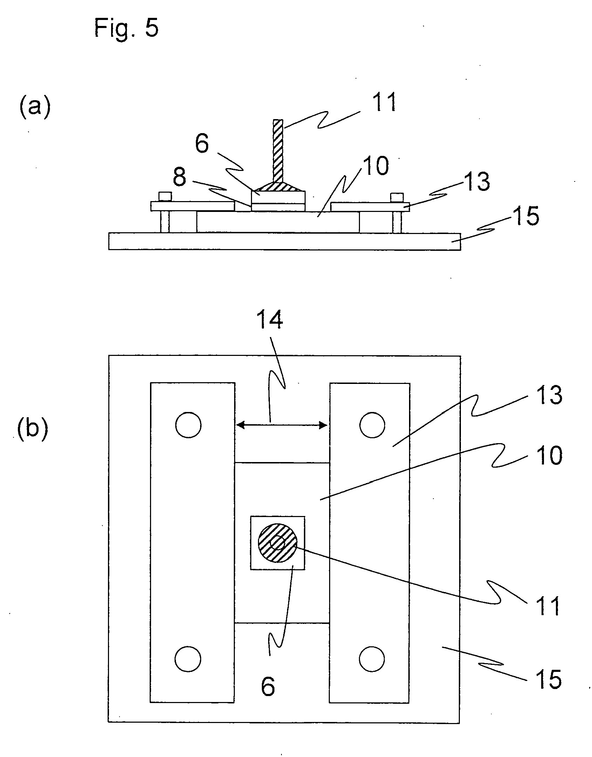

Herein, the adhesion force at the interface between a support film and a transfer layer is determined in the method described below. As a transfer-receiving material for evaluation (herein referred to as a transfer-receiving material), a low alkali glass substrate (measuring 30 mm × 30 mm, 1.1 mm in thickness), Model No. 1737, manufactured by Corning Incorporated is used. First, attached materials are removed from the surface of the transfer-receiving material without scratching the surface, and washed well by ultrasound irradiation or the like, and then subjected to plasma irradiation so as to exhibit sufficient adhesion to a transfer layer. Onto a center portion of the transfer-receiving material thus prepared, a transfer film measuring 10 mm × 10 mm is placed so as to bring the surface on the transfer layer side of the transfer film into contact with the transfer-receiving material, and a cushioning material, Model F200, manufactured by KINYOSHA CO., LTD. is placed on the surface on the support film side of the transfer film. Then, pressure is applied for 10 seconds at a press temperature of 20°C under a press pressure of 3.8 MPa to obtain a three-layered laminate of transfer-receiving material/transfer layer/support film. As illustrated in Fig. 3, a 7.1-mm aluminum stud pin 11 manufactured by Phototechnica Corporation is adhered at the center of the surface on the support film side of the resulting laminate, fixed with a mounting clip 12 manufactured by Phototechnica Corporation, and subjected to curing at normal temperature for 24 hours. After curing, the mounting clip 12 is removed to obtain a sample for testing adhesion force which has the stud pin 11 adhered on the three-layered laminate of glass/transfer layer/support film as illustrated in Fig. 4. As illustrated in Fig. 5, the transfer-receiving material 10 of the sample obtained is placed on the lower platen 15 of a desktop tester EZTest, Model EZ-S, manufactured by Shimadzu Corporation and fixed by pressing the transfer-receiving material 10 with fixing aluminum plates 13. The fixing aluminum plates 13 are adjusted to be in parallel with the side of the transfer-receiving material 10, and the distance 14 between the aluminum fixing plates is set to be 15 mm. The stud pin 11 is allowed to be held by a load cell of the tester. The stud pin is pull upward at a fixed speed of 10 mm/min in a tensile testing mode. The maximum stress at which delamination is caused between the transfer layer and the support film is defined as the adhesion force at the interface between the support film and the transfer layer.

The adhesion force varies, depending not only on the surface free energy of each of the materials constituting the interfacial surface in a laminate, but also on the shape of the interfacial surface, the thickness of the transfer layer, complexation, post-processing conditions after complexation, and others. Thus, it is preferable that these conditions are designed to fall within the preferable ranges mentioned above. For example, in the case of using a support film having a fine concave-convex structure on the surface thereof, the adhesion force between the transfer layer and the support film is increased in comparison to cases of using a support film of which the surface is flat, and thus it is preferable that the surface free energy of a support film is lower within a range which allows coating of a transfer layer. In addition, in the case of a transfer layer having a thick thickness, the adhesion force between the support film and the transfer layer is decreased, and thus it is possible to obtain an appropriate adhesion for.ce by increasing its surface free energy.

[Hardness of Transfer Layer]

The transfer layer preferably has a hardness of 0.1 to 0. 6 GPa. The measurement method will be described in detail below, and the hardness as used here means the Mayer hardness and is a hardness which is measured by pressing a triangular pyramid indenter to a depth corresponding to the thickness of the transfer layer. A transfer layer having a hardness of more than 0.6 GPa is likely to cause insufficient adhesion of the transfer layer surface to a transfer-receiving material in pressing and transferring the transfer layer onto the transfer-receiving material, whereby the transferring of the transfer layer cannot be achieved. A transfer layer having a hardness of less than 0.1 GPa, on the other hand, is likely to cause the transfer layer to be pressed flat and deformed or the thickness of the transfer layer to be varied when the transfer layer has been pressed onto a transfer-receiving material.

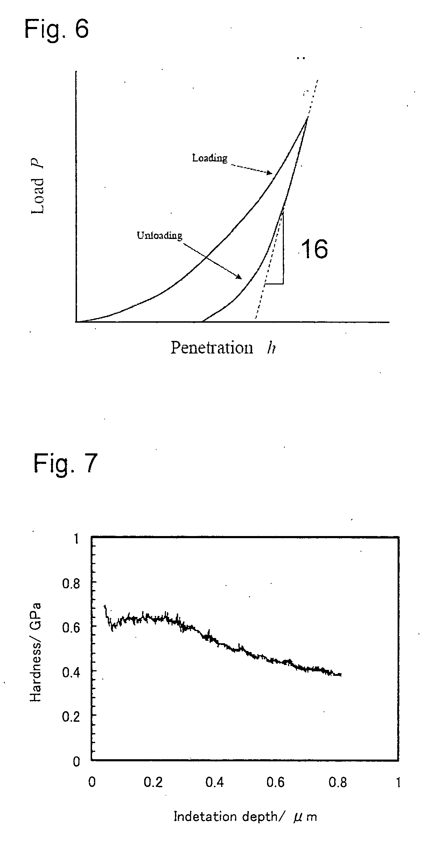

The hardness in the present invention can be calculated from a load-indentation diagram which is obtained by measurement using a nano-indentation method. Briefly, on a specimen allowed to stand still, a diamond indenter of a regular triangular pyramid shape, that is, a Berkovich indenter, is used to press the indenter to the depth equal to the thickness of the transfer layer, thereby carrying out a load/unload test and obtain a load-indentation depth diagram (Fig. 6). As represented by the formula shown below, the hardness can be calculated by dividing the load at the indentation point by the projected area of the indenter that is obtained by applying the Oliver-Pharr approximation in the load-indentation depth diagram.

$$H = P/A$$

$$A = \eta k h_c$$

where H denotes the hardness, P denotes the load, A denotes the contact projected area, $\eta$ denotes a correction factor for the indenter tip shape, and k denotes a coefficient which depends on the geometric shape of the indenter, and is 24.56 for the Berkovichindenter. Furthermore, $h_c$ denotes an effective contact depth, and is expressed by the following equation:

$$h_c = h - \varepsilon P/(dp/dh)$$

where h denotes the entire displacement measured, dP/dh denotes an initial slope 16 during unloading in a load-indentation depth diagram obtained by the measurement, as illustrated in Fig. 6. Furthermore, $\varepsilon$ denotes a constant which depends on the geometric shape of the indenter, and is 0.75 for the Berkovich indenter.

In this measurement, measurements are made using a continuous stiffness measurement method in which the indenter is subjected to microvibration in the indentation testing and the response amplitude and phase difference to the vibration are acquired as a function of time, to obtain a hardness-indentation depth diagram (Fig. 7). The hardness corresponding to the indentation depth is affected by the hardness of a film which is a supporting material of the transfer layer, when the indentation depth is large. Therefore, the average value of hardness in a region where the ratio of the indentation depth to the transfer layer thickness ranges from 0 to 0.125 is defined as the hardness of the transfer layer.

[Morphology of Surface of Support Film in Contact with Transfer Layer]

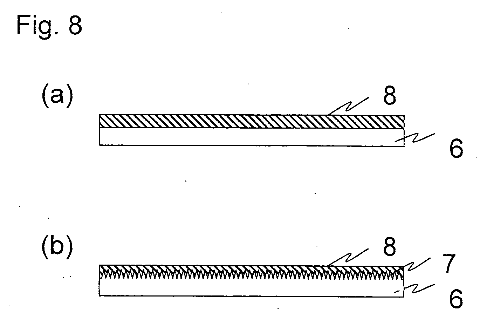

The surface of the support film, which comes into contact with the transfer layer, may be either flat or irregular. For example, the interfacial surface between the transfer film 6 and the transfer layer 8 may be flat as illustrated in Fig. 8(a), or the interface between the transfer film 6 and the transfer layer 8 may have a fine concave-convex shape 7 as illustrated in Fig. 8(b). When the interface between the support film and the transfer layer has a concave-convex shape, the surface of the transfer layer which has been transferred onto a transfer-receiving material will have the corresponding concave-convex shape, thereby making it possible to provide a coated material of which the outermost surface has a concave-convex shape.

The concave-convex shape may be of either a geometric or random shape. Geometric shapes include prism, moth eye, depressed truncated cone, semispherical, spherical, and the like. As used herein, a depressed truncated cone shape means a concave-convex shape in which the shape of the recess is a truncated cone.

There is no particular limitation on the method for forming a concave-convex shape on the surface of a support film, and known methods can be applied, such as thermal imprinting, UV imprinting, coating, etching, and the like.

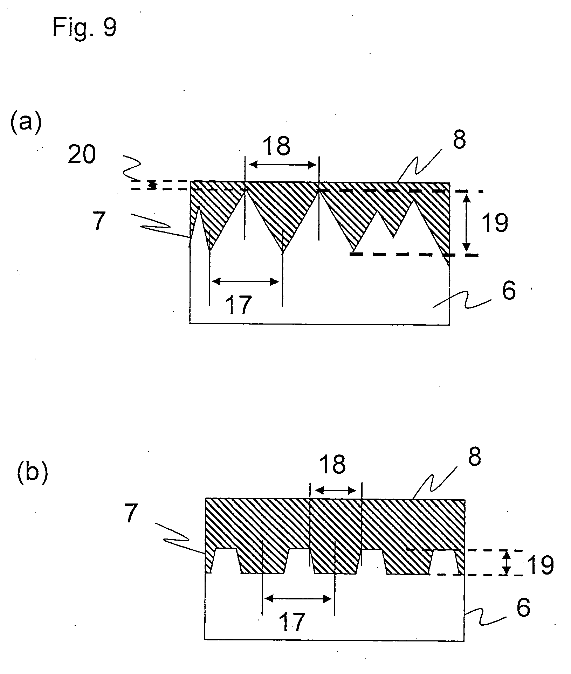

The concave-convex shape which is formed on the outermost surface of a transfer layer preferably has a representative pitch of 0.01 to 10 $\mu$m, and more preferably 0.1 to 8 $\mu$m, on the transfer layer. The representative pitch of a concave-convex shape on a transfer layer means the pitch of repeated shapes, when the concave-convex shape is of a geometric shape, and the average value of pitches at ten optionally selected positions, when the concave-convex shape is of a random shape. As used herein, the pitch is defined as the horizontal distance 17 between the positions which correspond to the respective maximum heights of two adjacent protrusions on the transfer layer, as illustrated in Fig. 9(a). When the top portion of the protrusion is flat as illustrated in Fig. 9(b), the pitch is defined as the horizontal distance 17 between the centers of two adjacent protrusions. A concave-convex shape having a representative pitch of less than 0.01 $\mu$m is likely to cause foreign matter to be caught within recesses between the shaped portions, and is likely not to provide the intended structure. A concave-convex shape having a representative pitch of more than 10 $\mu$m, on the other hand, results in a reduced density of protrusions and is likely to provide an insufficient effect of the concave-convex structure.

The aspect ratio of a concave-convex shape which is formed on the outermost surface of a transfer layer is preferably from 0.01 to 3.0. As described with reference to Fig. 9, the aspect ratio is a value of the convex height 19 divided by the width 18 of the protrusion on the transfer layer. Herein, the height 19 of the protrusion means the vertical distance between the protrusion and the recess which are adjacent on the transfer layer. When the depths of recesses on both sides of the protrusion are different, the vertical distance on a side on which the height 19 of the protrusion is more than that on the other side is defined as the height of the protrusion. In addition, when aspect ratios of a concave-convex shape on a transfer layer are varied, the average value of aspect ratios of the concave-convex shape at ten randomly selected positions is employed as a value of aspect ratio. A concave-convex shape having an aspect ratio of less than 0.01 has a very small amount of protrusions and is likely to be difficult in providing effects of the concave-convex shape. A concave-convex shape having an aspect ratio of more than 3.0, on the other hand, is incapable of filling the concave-convex shape on a support film with the transfer layer, resulting in deterioration of mold releasability between the support film and the transfer layer and causes protrusions to be torn off during transferring, or is likely to cause protrusions to collapse.

The pitch and aspect ratio of the surface concave-convex shape of a transfer layer are determined by cutting a transfer film on a microtome and observing the cross-section of the transfer film by a scanning electron microscope. The magnification for observation and measurement is 50,000 times when the higher of the pitch and height values of a concave-convex shape is 0.01 to 0.2 $\mu$m, 20,000 times when the higher of the pitch and height values of a concave-convex shape is 0.2 to 2 $\mu$m, 5,000 times when the higher of the pitch and height values of a concave-convex shape is 2 to 5 $\mu$m, and 2,500 times when the higher of the pitch and height values of a concave-convex shape is from 5 to 10 $\mu$m.

[Uniformity of Residual Film Thickness of Transfer Layer]

The uniformity of residual film thickness of a transfer layer means a minimum value of the thickness between the surface of the transfer layer which comes into contact with a transfer-receiving material and the surface of the transfer layer which comes into contact with the support film. When a transfer layer is flat, the residual film thickness of the transfer layer is equal to the thickness of the transfer layer. When a transfer layer has a concave-convex shape, the residual film thickness of the transfer layer is defined as the distance between the surface of the transfer layer which comes into contact with a transfer-receivingmaterial and the recess on the transfer layer, that is, the distance between the transfer layer and a transfer-receiving material which correspond to the minimum thickness of the transfer layer. As described with reference to the drawing, the distance indicated by 20 in Fig. 9(a) is a residual film thickness. In addition, the value obtained by dividing the difference in residual film thicknesses, which is given by the difference between the maximum value and the minimum value that are obtained by measuring residual film thickness at ten positions, by the average value of these residual film thicknesses is defined as the uniformity of residual film thickness. The uniformity of residual film thickness is preferably 25% or less, and more preferably 15% or less. A residual film thickness of more than 25% is likely to cause the occurrence of transfer irregularity or defects during contacting the transfer layer with a transfer-receiving material and pressing the transfer layer onto the transfer-receiving material, or to result in irregularity in shape and size during etching of the concave-convex shape which is formed on a transfer-receiving material. The residual film thickness of a transfer layer is determined by cutting a transfer film on a microtome and observing the cross-section of the transfer film by a scanning electron microscope, as in the method for measuring the thickness of a transfer layer. The magnification for observation and measurement is 50, 000 times in the case of residual film thicknesses of 0.01 to 0.2 $\mu$m, 20,000 times in the case of residual film thicknesses of 0.2 to 2 $\mu$m, 5,000 times in the case of residual film thicknesses of 2 to 5 $\mu$m, and 2,500 times in the case of residual film thicknesses of 5 to 10 $\mu$m.

[Transfer Method]

The method for transferring a transfer layer onto a transfer-receiving material using a transfer film of the present invention will be described. It is possible to transfer a transfer layer onto a transfer-receiving material by bringing the surface on the transfer layer side of the transfer film into contact with the transfer-receiving material to form a laminate, followed by application of a pressure or heating under a pressure. The method for application of a pressure in the case of transfer includes, but is not limited to, a method for application of a pressure using a nip roll or a press. The pressure to be applied to the laminate is preferably from 1 kPa to 50 MPa. The pressure of less than 1 kPa may sometimes cause transfer defects, while the pressure of more than 50 MPa may sometimes cause collapse of a concave-convex shape of a support film or breakage of transfer-receiving material. In the case of applying a pressure, it is also possible to use a cushioning material between a support film of the laminate and a pressure plate or a pressure roll. Use of the cushioning material enables transfer of a transfer layer with high accuracy without involving air. It is possible to use, as the cushioning material, a fluorine rubber, a silicone rubber, an ethylene-propylene rubber, an isobutylene-isoprene rubber, an acrylonitrile-butadiene rubber and the like. It is also possible to heat under a pressure so as to allow a transfer layer to sufficiently adhere to a transfer-receiving material.

[Treatment after Transfer]

After transferring a transfer layer onto a transfer-receiving material, a high-temperature heat treatment can also be performed so as to perform vitrification by the progress of polymerization of a siloxane oligomer contained in the transfer layer. The high-temperature heat treatment may be applied to either a laminate of transfer-receiving material/ transfer layer/support film, or a two-layered laminate of transfer-receiving material/transfer layer, from which a support film is peeled off. When the support film is peeled off before the heat treatment so as to obtain the two-layered laminate of transfer-receiving material/transfer layer, the support film is peeled off at a press temperature or lower after transfer. The temperature in the case of peeling the support film of higher than the press temperature may cause collapse of the shape of the transfer layer, or a decrease in peelability between the transfer layer and the support film. The temperature of the high-temperature heat treatment can be appropriately set depending on heat resistance, chemical resistance and reliability required to the laminate. For example, when a transfer layer is allowed to serve as a protective film or used to impart a concave-convex shape to the surface of a glass plate by transferring to an inorganic material plate such as a glass plate, the heat treatment temperature is preferably from 150 to 1,000°C, more preferably from 180 to 800°C, and most preferably from 200 to 400°C. When the heat treatment is performed at a temperature lower than 150°C, condensation of a siloxane oligomer may not sometimes make sufficient progress, leading to insufficient solidification or deterioration of heat resistance. On the other hand, when the heat treatment is performed at a temperature higher than 1,000°C, cracking may sometimes occur in the transfer layer or collapse of the concave-convex shape. When the transfer layer transferred onto the transfer-receiving material made of an inorganic material or crystal material having a low etching rate is used as a resist film, there is a need to decrease the etching rate of the transfer layer than that of the transfer-receiving material. It is effective to convert an organic component in the transfer layer into a dense silicon dioxide film by burning out, so that the heat treatment temperature is preferably from 700 to 1,200°C. When the heat treatment temperature of lower than 700°C, the transfer layer may not be sometimes densified sufficiently, and thus fail to be used as an etching resist film. When the heat treatment temperature is higher than 1,200°C, cracking may occur in the transfer layer. In the case of the high-temperature heat treatment, collapse of a concave-convex shape can also be prevented by prebaking at a temperature lower than the high-temperature heat treatment temperature before the treatment.

[Examples]

The present invention will be specifically described based on Examples, but the present invention is not limited only to the Examples.

(1) Evaluation of Surface Free Energy of Support Film

Using Contact Angle Meter, Model CA-X, manufactured by Kyowa Interface Science Co., Ltd., a contact angle of a support film was measured, and surface free.energy corrected based on a standard value was determined by the method mentioned above. The measurement was repeated five times, and the average value was defined as a value of a contact angle.

(2) Evaluation of Coatability and Evaluation of Transferability

A siloxane sol was coated on a support film measuring 30 mm × 30 mm so as to obtain a thickness of each transfer layer shown in Table 2, and the coatability was evaluated. When the thickness of the transfer layer is 5 $\mu$m or less, coating was performed using a spin coater, Model No. 1H-DX2, manufactured by MIKASA CO., LTD. When the thickness of the transfer layer is more than 5 $\mu$m, coating was performed using a Baker applicator.
The coatability was evaluated by the following criteria.

A: No cissing occurs, satisfactory coatability
B: Cissing occurs, coatable
C: Impossible to form a transfer layer because of cissing or cracking of a transfer layer, or non-coatable

(3) Measurement of Content of Silicon Atoms relative to Total Numbers of Carbon, Oxygen and Silicon Atoms by X-Ray Photoelectron Spectroscopy (XPS)

The content of silicon atoms relative to the total numbers of carbon, oxygen and silicon atoms of a transfer layer was measured by a scanning type X-ray photoelectron spectroscopy apparatus PHI Quantera SXM (X ray source: AlK$\alpha$) manufactured by ULVAC-PHI, Inc. Regarding the measured data, a peak corresponding to C1s bond energy was corrected to 284.4 eV, and then the determination was performed using a relative sensitivity factor (RSF) focusing on a peak at around 102 to 103 eV corresponding to Si2p and a peak at around 530 to 535 eV corresponding to O1s.

(4) Thickness of Transfer Layer and Evaluation of Residual Film Thickness

(4-1) Measurement of Thickness of Transfer Layer and Residual Film Thickness

A transfer film was cut by a rotary microtome, Model No. RMS, manufactured by manufactured by Nippon Microtome Laboratory, and the cross-section was observed and measured by miniSEM, Model No. ABT-32, manufactured by TOPCON CORPORATION. Magnification and the measurement method were as mentioned in the above conditions.

(4-2) Calculation of Uniformity of Residual Film Thickness

When a transfer layer is flat, the measurement was performed at ten randomly selected positions of the transfer layer. When the transfer layer has a concave-convex shape, the measurement was performed at ten randomly selected minimum points of the thickness. The difference between the maximum value and the minimum value of the thus obtained residual film thicknesses at ten points was defined as a difference in residual film thickness. The value expressed as a percentage, which is determined by dividing the difference in residual film thickness by the average value of residual film thicknesses at ten points, was defined as uniformity of the residual film thickness.

(5) Evaluation of Concave-Convex Shape of Transfer Layer

A transfer film was cut by a rotary microtome, Model No. RMS, manufactured by manufactured by Nippon Microtome Laboratory, and the cross-section was observed and measured by miniSEM, Model No. ABT-32, manufactured by TOPCON CORPORATION. Magnification and the measurement method were as mentioned in the above conditions.

(6) Evaluation of Hardness of Transfer Layer

(6-1) Preparation of Sample

(6-2) Measurement Conditions

Using a transfer film, the measurement was performed under the following conditions to obtain a load-indentation depth diagram.
Measuring apparatus: Ultra-micro hardness tester Nano Indenter XP manufactured by MTS Systems Corporation
Measurement method: Nanoindentation method, Continuous stiffness measurement method
Indenter used: Diamond indenter of a regular triangular pyramid shape (Berkovich indenter)
Measurement atmosphere: Atmospheric air at 25°C

(6-3) Evaluation of Transfer Layer Hardness

Hardness corresponding to an indentation depth was calculated from the load-indentation depth diagram obtained under the above conditions, and a hardness-indentation depth diagram was made. In the hardness-indentation depth diagram, the value obtained by averaging hardness data, in a range where indentation depth/transfer layer thickness is from 0 to 0.125, was defined as hardness of the transfer layer.

(7) Evaluation of Transferability and Transfer Defects of Transfer Layer

Immediately after production of a transfer film, the transfer layer was transferred onto a transfer-receiving material under the conditions shown below, and transferability was evaluated from the transfer area ratio.

(7-1) Preparation of Transfer-Receiving Material

After removing dusts adhered to the surface of a low alkali glass, Model No. 1737 (measuring 30 mm $\times$ 30 mm, 1.1 mm in thickness) manufactured by Corning Incorporated, which is a transfer-receiving material, using a blower, washing was repeated twice at 45 kHz for 10 minutes in a state of being immersed in pure water, using a triple frequency ultrasonic cleaner, Model No. VS-100III, manufactured by AS ONE Corporation. Thereafter, the surface of the transfer-receiving material was subjected to plasma irradiation at 15, 000 VAC for 5 minutes, using a desktop vacuum plasma equipment manufactured by SAKIGAKE-Semiconductor Co., Ltd.

(7-2) Transfer Method

The surface of a transfer film measuring 20 mm $\times$ 20 mm was brought into contact with a glass substrate prepared in (7-1) as a transfer-receiving material. Furthermore, a cushioning material, Model F200, manufactured by KINYOSHA CO., LTD. was placed on the surface on the support film side of the transfer film. Then, pressure was applied for 10 seconds at a press temperature of 20°C under a press pressure of 1.38 MPa, and then the support film was peeled off at room temperature.

(7-3) Transfer Area Ratio and Evaluation of Appearance of Transfer Layer

A transfer area ratio was calculated by dividing the area of the transfer layer transferred onto the transfer-receiving material by the size of 20 mm $\times$ 20 mm of the transfer film. Evaluation criteria of the transfer area ratio were defined as follows.

    A: Transfer area ratio is 100%, satisfactory transferability
    B: Transfer area ratio is 90% or more and less than 100%
    C: Transfer area ratio is 10% or more and less than 90%
    D: Transfer area ratio is 0% or more and less than 10%

Evaluation criteria of appearance of a transfer layer were defined as follows, and then evaluation was performed.
Good: Cracking measuring 2.0 $\mu$m or more in width and 5 mm or more in length.is not observed in transfer layer
Poor: Cracking measuring 2.0 $\mu$m or more in width and 5 mm or more in length is observed in transfer layer

(8) Measurement of Adhesion at Interface between Support Film and Transfer Layer

(8-1) Preparation of Transfer-Receiving Material

After removing dusts adhered to the surface of a low alkali glass, Model No. 1737 (measuring 30 mm $\times$ 30 mm, 1.1 mm in thickness) manufactured by Corning Incorporated, which is a transfer-receiving material for evaluation, using a blower, washing was repeated twice at 45 kHz for 10 minutes in a state of being immersed in pure water, using a triple frequency ultrasonic cleaner, Model No. VS-100III, manufactured by AS ONE Corporation. Thereafter, the surface of the transfer-receiving material was subjected to plasma irradiation at 15,000 VAC for 5 minutes, using a desktop vacuum plasma equipment manufactured by SAKIGAKE-Semiconductor Co., Ltd.

(8-2) Measurement of Adhesion Force

Using a desktop tester EZTest, Model EZ-S, manufactured by Shimadzu Corporation, an adhesion force at the interface between a support film and a transfer layer was measured by the above-mentioned method. The measurement was performed five times, and the average value was defined as an adhesion force.

[Example 1]

"ZEONOR film (registered trademark)", Model No. ZF14, manufactured by Zeon Corporation, which is a 60 $\mu$m thick film made of a cyclic polyolefin-based resin, having no concave-convex shape on the surface, was used as a support film. Surface free energy of the support film was determined by the above-mentioned method and found to be 34. 3 mN/m. Next, a siloxane sol OCNL505, Model No. 14000, manufactured by TOKYO OHKA KOGYO CO., LTD. was coated on the above support film, and the coated support film was left to stand at 25°C under 0.1 atm for 3 minutes, followed by drying under reduced pressure to obtain a transfer film in which a transfer layer made of a siloxane oligomer is formed on the support film. The transfer layer had a thickness of 9.56 $\mu$m, and uniformity of the transfer layer thickness was 2%. Coatability was satisfactory. The content of silicon atoms relative to the total numbers of carbon, oxygen and silicon atoms as measured by X-ray photoelectron spectroscopy (XPS) of the transfer layer was 25%, and the transfer layer had a hardness of 0.12 GPa. An adhesion force at the interface between a film as a support film and a transfer layer was 0.02 MPa.

[Example 2]

In the same manner as in Example 1, except that the thickness of the transfer layer was changed to 0.04 $\mu$m, a transfer film was obtained. Uniformity of the residual film thickness of a transfer layer was 23%, and coatability was satisfactory. The transfer layer had a hardness of 0.10 GPa, and an adhesion force at the interface between a support film and a transfer layer was 0.48 MPa.

[Example 3]

In the same manner as in Example 1, except that the thickness of the transfer layer was changed to 4.83 $\mu$m, a transfer film was obtained. Uniformity of the residual film thickness of a transfer layer was 11%, and coatability was significantly satisfactorily. The transfer layer had a hardness of 0.12 GPa, and an adhesion force at the interface between a support film and a transfer layer was 0.21 MPa.

[Example 4]

In the same manner as in Example 1, except that the thickness of the transfer layer was changed to 0.37 $\mu$m, a transfer film was obtained. Uniformity of the residual film thickness of a transfer layer was 14%, and coatability was significantly satisfactorily. The transfer layer had a hardness of 0. 13 GPa, and an adhesion force at the interface between a support film and a transfer layer was 0.38 MPa.

[Example 5]

In the same manner as in Example 1, except that a siloxane sol obtained by condensation of tetramethoxysilane was used, a transfer film was obtained. The content of silicon atoms relative to the total numbers of carbon, oxygen and silicon atoms as measured by X-ray photoelectron spectroscopy (XPS) of the transfer layer was 31%, the transfer layer had a thickness of 4.63 $\mu$m, and uniformity of the residual film thickness was 8%. Coatability was significantly satisfactorily. The transfer layer had a hardness of 0.15 GPa, and an adhesion force at the interface between a support film and a transfer layer was 0.18 MPa.

[Example 6]

In the same manner as in Example 5, except that the thickness of the transfer layer was changed to 0.15 $\mu$m, a transfer film was obtained. Uniformity of the residual film thickness of a transfer layer was 22%. The transfer layer had a hardness of 0.17 GPa, and an adhesion force at the interface between a support film and a transfer layer was 1.69 MPa.

[Example 7]

In the same manner as in Example 1, except that a siloxane sol obtained by hydrolysis and dehydration condensation of colloidal silica particles, Model No. PL-2L (average particle size of 17 nm, specific surface area conversion method) manufactured by FUSO CHEMICAL CO., LTD., methylsiloxane, phenylsiloxane and dimethylsiloxane was used as the siloxane sol, a transfer film was obtained. The content of silicon atoms relative to the total numbers of carbon, oxygen and silicon atoms as measured by X-ray photoelectron spectroscopy (XPS) of the transfer layer was 19%. Coatability was generally satisfactory, the transfer layer had a thickness of 3.20 $\mu$m, uniformity of the residual film thickness was 7%, the transfer layer had a hardness of 0.19 MPa, and an adhesion force at the interface between a support film and a transfer layer was 0.81 MPa.

[Example 8]

In the same manner as in Example 7, except that the thickness of the transfer layer was changed to 0.09 $\mu$m, a transfer film was obtained. Uniformity of the residual film thickness of a transfer layer was 14%. The transfer layer had a hardness of 0.'18 MPa, and an adhesion force at the interface between a support film and a transfer layer was 1.08 MPa.

[Example 9]

"TORETEC (registered trademark)", Model No. 7721, manufactured by Toray Advanced Film Co., Ltd., which is a 45 $\mu$m thick film made of a polyolefin-based resin, having no concave-convex shape on the surface, was used as a support film. Surface free energy was determined by the above-mentioned method and found to be 33.4 mN/m. Next, a sol prepared by dissolving polysilsesquioxane SR-21 manufactured by KONISHI CHEMICAL IND.CO., LTD. in propylene glycol monomethyl ether acetate was coated on the above support film, followed by drying with heating at 120°C for 1 hour to obtain a transfer film in which a transfer layer made of a siloxane oligomer is formed on the support film. The siloxane sol exhibited satisfactory coatability. The transfer layer had a thickness of 8.65 $\mu$m, uniformity of the residual film thickness of a transfer layer was 2%, and coatability was satisfactory. The content of silicon atoms relative to the total numbers of carbon, oxygen and silicon atoms as measured by X-ray photoelectron spectroscopy (XPS) of the transfer layer was 9%, and the transfer layer had a hardness of 0.1 GPa. An adhesion force at the interface between a support film and a transfer layer was less than 0.02 MPa.

[Example 10]

In the same manner as in Example 9, except that the thickness of the transfer layer was changed to 0.64 $\mu$m, a transfer film was obtained. Uniformity of the residual film thickness of a transfer layer was 5%. The transfer layer had a hardness of 0.1 MPa, and an adhesion force at the interface between a support film and a transfer layer was 0.28 MPa.

[Example 11]

In the same manner as in Example 9, except that, the siloxane sol was coated, followed by being left to stand at 25°C under 0.1 atm for 3 minutes and further drying under reduced pressure, thereby adjusting the thickness of a transfer film to 4.21 $\mu$m, a transfer film was obtained. Uniformity of the residual film thickness of a transfer layer was 4%, the transfer layer had a hardness of 0.03 MPa, and an adhesion force at the interface between a support film and a transfer layer was 0.07 MPa.

[Example 12]

In the same manner as in Example 1, except that a 60 $\mu$m thick film formed by a melt extrusion method using a resin "TOPAS (registered trademark)", Model No. 6013, manufactured by Polyplastics Co. , Ltd. , which is a cyclic polyolefin-based resin, was used as a support film, a transfer film was obtained. The support filmhad surface free energy of 38.2 mN/m, and coatability was significantly satisfactorily. The thickness of the transfer layer of the obtained transfer film was 9.88 $\mu$m, and uniformity of the residual film thickness was 2%. The transfer layer had a hardness of 0.13 GPa, and an adhesion force at the interface between a support film and a transfer layer could not be measured since it is less than 0.02 MPa.

[Example 13]

In the same manner as in Example 12, except that the thickness of the transfer layer was changed to 0.06 $\mu$m, a transfer film was obtained. Uniformity of the residual film thickness of a transfer layer was 11%, the transfer layer had a hardness of 0. 11 MPa, and an adhesion force at the interface between a support film and a transfer layer was 1.28 MPa.

[Example 14]

An ultraviolet curable acrylic resin ARONIX UV3701 manufactured by TOAGOSEI CO., LTD. was coated on a 250 $\mu$m thick polyester film "Lumilar (registered trademark)", Model No. U34, manufactured by Toray Industries, Inc. in a thickness of 10 $\mu$m to form a support film. Surface free energy of the UV3701 surface of the support film was determined by the above-mentioned method and found to be 34.9 mN/m. Next, an OCNL505 siloxane sol manufactured by TOKYO OHKA KOGYO CO., LTD. was coated on the UV3701 surface of the support film, and then the coated support filmwas left to stand at 25°C under 0.1 atm for 5 minutes, followed by drying under reduced pressure to obtain a transfer film in which a transfer layer made of a siloxane oligomer is formed on the support film. Coatability was significantly satisfactorily. The content of silicon atoms relative to the total numbers of carbon, oxygen and silicon atoms as measured by X-ray photoelectron spectroscopy (XPS) of the transfer layer was 25%. The transfer layer had a thickness of 3.64 $\mu$m, and uniformity of the residual film thickness was 20%. The transfer layer had a hardness of 0.15 GPa, and an adhesion force at the interface between a support film and a transfer layer was 0.69 MPa.

[Example 15]

Amixture of a silicone resin Model No. ZX-101 manufactured by FUJI KASEI CO., LTD. with "IRGACURE (registered trademark)", Model No. 250, manufactured by BASF Japan Ltd. in a weight ratio of 100/3.3 was coated on a 50 $\mu$m thick polyester film "Lumilar (registered trademark)", Model No. U34, manufactured by Toray Industries, Inc. in a thickness of 5 $\mu$m to form a support film. Surface free energy of the ZX-101 surface of the support film was determined by the above-mentioned method and found to be 20.5 mN/m. Next, an OCNL505 siloxane sol manufactured by TOKYO OHKA KOGYO CO., LTD. was coated on the ZX-101 surface of the support film, and then the coated support film was left to stand at 25°C under 0.1 atm for 3 minutes, followed by drying under reduced pressure to obtain a transfer film in which a transfer layer made of a siloxane oligomer is formed on the support film. Coatability was satisfactory. The content of silicon atoms relative to the total numbers of carbon, oxygen and silicon atoms as measured by X-ray photoelectron spectroscopy (XPS) of the transfer layer was 25%. The transfer layer had a thickness of 2.41 $\mu$m, and uniformity of the residual film thickness was 4%. The transfer layer had a hardness of 0.16 GPa, and an adhesion force at the interface between a support film and a transfer layer was 0.05 MPa.

[Example 16]

In the same manner as in Example 15, except that the ZX-101 surface was subjected to a corona treatment to obtain a support film, a transfer film was obtained. The support film had surface free energy of 64.8 mN/m, the transfer layer had a thickness of 1.62 $\mu$m, and uniformity of the residual film thickness was 3%. The transfer layer had a hardness of 0. 14 GPa, and an adhesion force at the interface between a support film and a transfer layer was 0.12 MPa.

[Example 17]

In the same manner as in Example 1, except that the siloxane sol was coated, followed by drying under reduced pressure and further a heat treatment at 90°C for 1 hour, a transfer film was obtained. The transfer layer had a thickness of 0.86 $\mu$m, and uniformity of the residual film thickness was 6%. The transfer layer had a hardness of 0.31 GPa, and an adhesion force at the interface between a support film and a transfer layer was 0.29 MPa.

[Example 18]

In the same manner as in Example 1, except that the siloxane sol was coated, followed by drying under reduced pressure and further a heat treatment at 120°C for 1 hour, a transfer film was obtained. The transfer layer had a thickness of 0.76 $\mu$m, and uniformity of the residual film thickness was 7%. The transfer layer had a hardness of 0. 63 GPa, and an adhesion force at the interface between a support film and a transfer layer was 0.38 MPa.

[Example 19]

In the same manner as in Example 1, except that the shape of the surface of the support film, which comes into contact with the transfer layer, was changed to a prism shape having a pitch of 5 $\mu$m and an aspect ratio of 0.5, a transfer film was obtained. The support film had surface free energy of 42.9 mN/m, the transfer layer had a thickness of 6.96 $\mu$m, and uniformity of the residual film thickness was 4%. The transfer layer had a hardness of 0.17 GPa, and an adhesion force at the interface between a support film and a transfer layer was 0.17 MPa.

[Example 20]

In the same manner as in Example 1, except that the shape of the surface of the support film, which comes into contact with the transfer layer, was changed to a prism shape having a pitch of 10 $\mu$m and an aspect ratio of 0.5, a transfer film was obtained. The support film had surface free energy of 46.4 mN/m, the transfer layer had a thickness of 8.2 $\mu$m, and uniformity of the residual film thickness was 6%. The transfer layer had a hardness of 0.14 GPa, and an adhesion force at the interface between a support film and a transfer layer was 1.65 MPa.

[Example 21]

In the same manner as in Example 1, except that the shape of the surface of the support film, which comes into contact with the transfer layer, was changed to a moth eye shape having a pitch of 0.25 $\mu$m and an aspect ratio of 1, a transfer film was obtained. The support film had surface free energy of 45.8 mN/m, the transfer layer had a thickness of 0.85 $\mu$m, and uniformity of the residual film thickness was 12%. The transfer layer had a hardness of 0.18 GPa, and an adhesion force at the interface between a support film and a transfer layer was 0.21 MPa.

[Example 22]

In the same manner as in Example 1, except that the shape of the surface of the support film, which comes into contact with the transfer layer, was changed to an inverted truncated cone shape having a pitch of 6.2 $\mu$m and an aspect ratio of 0.08, a transfer film was obtained. The support film had surface free energy of 38.2 mN/m, the transfer layer had a thickness of 0.18 $\mu$m, and uniformity of the residual film thickness was 8%. The transfer layer had a hardness of 0.16 GPa, and an adhesion force at the interface between a support film and a transfer layer was 0.33 MPa.

[Example 23]

In the same manner as in Example 1, except that the shape of the surface of the support film, which comes into contact with the transfer layer, was changed to an inverted truncated cone shape having a pitch of 0.25 $\mu$m and an aspect ratio of 2.8, a transfer film was obtained. The support film had surface free energy of 72.5 mN/m, the transfer layer had a thickness of 1.21 $\mu$m, and uniformity of the residual film thickness was 3%. The transfer layer had a hardness of 0. 15 GPa, and an adhesion force at the interface between a support film and a transfer layer was 0.89 MPa.

[Comparative Example 1]

Using a 100 $\mu$m thick polyester film "Lumilar (registered trademark)", Model No. U34, manufactured by Toray Industries, Inc. as a support film, and an ultraviolet curable acrylic resin ARONIX UV3701 manufactured by TOAGOSEI CO., LTD. was coated as a transfer layer to obtain a transfer film. The support film had surface free energy of 34.9 mN/m, the transfer layer had a thickness of 1.21 $\mu$m, and uniformity of the residual film thickness was 18%. The transfer layer had a hardness of 0.23 GPa. An adhesion force at the interface between a support film and a transfer layer could not be measured since it is larger than an adhesion force between the surface of glass as a transfer-receiving material and a transfer layer and thus fail to peel off.

[Comparative Example 2]

In the same manner as in Example 1, except that the thickness of the transfer layer was set to 0.008 $\mu$m, an attempt was made to produce a transfer film. However, cissing occurred during coating of a transfer layer, and thus fail to obtain a uniform transfer film.

[Comparative Example 3]

In the same manner as in Example 1, except that the thickness of the transfer layer was changed to 12 $\mu$m, a transfer film was obtained. Uniformity of the residual film thickness of a transfer layer was 7%, and the transfer layer had a hardness of 0.17 GPa. An adhesion force at the interface between a support film and a transfer layer could not be measured since it was less than 0.02 MPa. The transfer layer was transferred onto the transfer-receiving material, resulting in the occurrence of cracking due to shrinkage of the transfer layer.

[Comparative Example 4]

In the same manner as in Example 7, except that the thickness of the transfer layer was ser to 0.005 $\mu$m, an attempt was made to produce a transfer film. However, irregularity in thickness occurred in the transfer layer during coating of a transfer layer, and thus fail to obtain a uniform transfer film.

[Comparative Example 5]

In the same manner as in Example 7, except that the thickness of the transfer layer was changed to 14.6 $\mu$m, a transfer film was produced. Uniformity of the residual film thickness of a transfer layer was 16%, the transfer layer had a hardness of 0. 20 GPa, and an adhesion force at the interface between a support film and a transfer layer was 1. 63 MPa. The transfer layer was transferred onto the transfer-receiving material, resulting in the occurrence of cracking due to shrinkage of the transfer layer.

[Comparative Example 6]

In the same manner as in Example 1, except that a mixture of an ultraviolet curable acrylic resin ARONIX UV3701 manufactured by TOAGOSEI CO., LTD. with tetramethoxysilane was used as a transfer layer, a transfer film was obtained. The content of silicon atoms relative to the total numbers of carbon, oxygen and silicon atoms of the transfer layer as measured by XPS was 3%. The transfer layer had a thickness of 7.39 μm, and uniformity of the residual film thickness of a transfer layer was 9%. The transfer layer had a hardness of 0.15 GPa. Anadhesion force at the interface between a support film and a transfer layer could not be measured since it is larger than an adhesion force between the surface of glass as a transfer-receiving  material and a transfer layer and thus fail to peel off.

A transferability confirmation test of the transfer films produced in Examples 1 to 24 and Comparatives Examples 1 to 6 was performed. The results are shown in Table 2 and Table 3. In the transferability confirmation test, all of the transfer films of Examples 1 to 17 and 19 to 22 exhibited satisfactory transferability, and thus enabling formation of a low-defect siloxane layer on a transfer-receiving material. The transfer filmof Example 18 exhibited satisfactory appearance of a transfer film, but exhibited low conformability with a substrate because of a hard transfer layer, resulting in low transfer area ratio. The transfer film of Example 23 exhibited satisfactory appearance, but defects caused by cissing in the formation of the transfer layer were recognized. On the other hand, in Comparative Examples 1 and 6, it was impossible to transfer the transfer layer of the transfer film. In Comparative Examples 2 and 4, a transfer film could not be obtained due to cissing in the formation of the transfer layer. In Comparative Examples 3 and 5, cracking due to shrinkage of the transfer layer occurred, and thus obtaining a high-defect transfer layer. In Table 2 and Table 3, the siloxane oligomer was abbreviated to siloxane, the content of silicon atoms relative to the total numbers of carbon, oxygen and silicon atoms was abbreviated to the content of silicone atoms, and an adhesion force at the interface between a support film and a  transfer layer was abbreviated to an adhesion force.

[Table 2]

|  | Transfer layer | Content of silicon atoms (%) | Thickness of support film (μm) | Surface free energy of support film (mN/m) | Surface shape | |
|---|---|---|---|---|---|---|
|  |  |  |  |  | Typical pitch (μm) | Aspect ratio |
| Example 1 | Siloxane | 25 | 60 | 34.3 | None | None |
| Example 2 | Siloxane | 25 | 60 | 34.3 | None | None |
| Example 3 | Siloxane | 25 | 60 | 34.3 | None | None |
| Example 4 | Siloxane | 25 | 60 | 34.3 | None | None |
| Example 5 | Siloxane | 31 | 60 | 34.3 | None | None |
| Example 6 | Siloxane | 31 | 60 | 34.3 | None | None |
| Example 7 | Particle-contai ning siloxane | 19 | 60 | 34.3 | None | None |
| Example 8 | Particle-contai ning siloxane | 19 | 6 | 34.3 | None | None |
| Example 9 | Phenylsiloxane | 9 | 45 | 33.4 | None | None |

(continued)

| | Transfer layer | Content of silicon atoms (%) | Thickness of support film ($\mu$m) | Surface free energy of support film (mN/m) | Surface shape | |
|---|---|---|---|---|---|---|
| | | | | | Typical pitch ($\mu$m) | Aspect ratio |
| Example 10 | Phenylsiloxane | 9 | 45 | 33.4 | None | None |
| Example 11 | Phenylsiloxane | 9 | 45 | 33.4 | None | None |
| Example 12 | Siloxane | 25 | 60 | 38.2 | None | None |
| Example 13 | Siloxane | 25 | 60 | 38.2 | None | None |
| Example 14 | Siloxane | 25 | 260 | 34.9 | None | None |
| Example 15 | Siloxane | 25 | 55 | 20.5 | None | None |

| | Thickness of transfer layer ($\mu$m) | Uniformity of residual film thickness of transfer layer (%) | Adhesion force (MPa) | Hardness of transfer layer (GPa) | Coatability | Transferability | |
|---|---|---|---|---|---|---|---|
| | | | | | | Area ratio | Appearance |
| Example 1 | 9.56 | 2 | 0.02 | 0.12 | A | A | Good |
| Example 2 | 0.04 | 23 | 0.48 | 0.10 | B | B | Good |
| Example 3 | 4.83 | 11 | 0.21 | 0.12 | A | A | Good |
| Example 4 | 0.37 | 14 | 0.13 | 0.38 | A | A | Good |
| Example 5 | 4.63 | 8 | 0.16 | 0.18 | A | A | Good |
| Example 6 | 0.15 | 22 | 1.69 | 0.17 | A | A | Good |
| Example 7 | 3.26 | 7 | 0.81 | 0.19 | A | B | Good |
| Example 8 | 0.09 | 14 | 1.08 | 0.18 | A | B | Good |
| Example 9 | 8.65 | 2 | < 0.02 | 0.1 | A | B | Good |
| Example 10 | 0.64 | 5 | 0.28 | 0.1 | A | B | Good |
| Example 11 | 4.21 | 4 | 0.07 | 0.03 | A | A | Good |

(continued)

| | Thickness of transfer layer (μm) | Uniformity of residual film thickness of transfer layer (%) | Adhesion force (MPa) | Hardness of transfer layer (GPa) | Coatability | Transferability | |
|---|---|---|---|---|---|---|---|
| | | | | | | Area ratio | Appearance |
| Example 12 | 9.88 | 2 | < 0.02 | 0.13 | A | B | Good |
| Example 13 | 0.06 | 11 | 1.28 | 0.11 | B | B | Good |
| Example 14 | 3.64 | 20 | 0.69 | 0.15 | A | B | Good |
| Example 15 | 2.41 | 4 | 0.05 | 0.16 | B | B | Good |

[Table 3]

| | Transfer layer | Content of silicon atoms (%) | Thickness of support film (μm) | Surface free energy of support film (mN/m) | Surface shape | |
|---|---|---|---|---|---|---|
| | | | | | Typical pitch (μm) | Aspect ratio |
| Example 16 | Siloxane | 25 | 55 | 64.8 | None | None |
| Example 17 | Siloxane | 25 | 60 | 34.3 | None | None |
| Example 18 | Siloxane | 25 | 60 | 34.3 | None | None |
| Example 19 | Siloxane | 25 | 60 | 41.9 | 5 | 0.5 |
| Example 20 | Siloxane | 25 | 60 | 46.4 | 10 | 0.5 |
| Example 21 | Siloxane | 25 | 60 | 45.8 | 0.25 | 1 |
| Example 22 | Siloxane | 25 | 60 | 38.2 | 6.1 | 0.08 |
| Example 23 | Siloxane | 25 | 60 | 72.5 | 0.25 | 2.8 |
| Comparative Example 1 | Acrylic resin | 0 | 60 | 34.3 | None | None |
| Comparative Example 2 | Siloxane | 25 | 60 | 34.3 | None | None |
| Comparative Example 3 | Siloxane | 25 | 60 | 34.3 | None | None |
| Comparative Example 4 | Particle-containing siloxane | 19 | 60 | 34.3 | None | None |
| Comparative Example 5 | Particle-containing siloxane | 19 | 60 | 34.3 | None | None |
| Comparative Example 6 | Acrylic resin + Siloxane | 3 | 60 | 34.3 | None | None |

(continued)

| | Thickness of transfer layer ($\mu$m) | Uniformity of residual film thickness of transfer layer (%) | Adhesion force (MPa) | Hardness of transfer layer (GPa) | Coatability | Transferability | |
|---|---|---|---|---|---|---|---|
| | | | | | | Area ratio | Appearance |
| Example 16 | 1.62 | 3 | 0.12 | 0.14 | A | A | Good |
| Example 17 | 0.86 | 6 | 0.29 | 0.31 | A | B | Good |
| Example 18 | 0.76 | 7 | 0.38 | 0.63 | A | C | Good |
| Example 19 | 6.96 | 4 | 0.17 | 0.17 | A | A | Good |
| Example 20 | 8.20 | 6 | 1.65 | 0.14 | A | B | Good |
| Example 21 | 0.85 | 12 | 0.21 | 0.18 | A | A | Good |
| Example 22 | 0.18 | 8 | 0.33 | 0.16 | A | A | Good |
| Example 23 | 1.21 | 3 | 0.89 | 0.15 | B | C | Good |
| Comparative Example 1 | 1.21 | 18 | - | 0.23 | A | D | - |
| Comparative Example 2 | 0.008 | - | - | - | C | - | - |
| Comparative Example 3 | 11.9 | 7 | < 0.02 | 0.17 | A | B | Poor |
| Comparative Example 4 | 0.005 | - | - | - | C | - | - |
| Comparative Example 5 | 14.5 | 16 | 1.63 | 0.20 | A | B | Poor |
| Comparative Example 6 | 4.2 | 8 | - | 0.15 | A | D | - |

[INDUSTRIAL APPLICABILITY]

According to the present invention, it is possible to apply a low-defect siloxane layer, which is excellent in heat resistance and light resistance, to a transfer-receiving material with a large area by a simple production process. In particular, when the surface of a support film, which comes into contact with a transfer layer, has a concave-convex shape, it is possible to apply a siloxane layer with the surface having a fine concave-convex shape to a transfer-receiving material with a large area by a simple production process without the occurrence of cracking.

[Reference Signs List]

1:    Liquid droplet
2:    Points of both ends of liquid droplet
3:    Vertex of liquid droplet
4:    $\theta/2$
5:    Sample
6:    Support film
7:    Concave-convex shape on support film
8:    Transfer layer
9:    Thickness of transfer layer
10:    Transfer-receiving material

11: Stud pin
12: Mounting clip
13: Aluminum fixing plate
14: Distance between aluminum fixing plates
15: Lower platen
16: Initial slope during unloading
17: Pitch of concave-convex shape of transfer layer
18: Width of protrusion of transfer layer
19: Height of protrusion of transfer layer
20: Residual film thickness of transfer layer

**Claims**

1. A transfer film comprising a support film and a transfer layer having a thickness of 0.01 to 10 μm laminated on the support film, wherein the transfer layer contains a siloxane oligomer and the content of silicon atoms relative to the total numbers of carbon, oxygen and silicon atoms as measured by X-ray photoelectron spectroscopy of the transfer layer is from 5 to 33%.

2. The transfer film according to claim 1, wherein the support film has a thickness of 5 to 500 μm.

3. The transfer filmaccording to claim 1 or 2, wherein the support film has surface free energy of 23 to 70 mN/m.

4. The transfer film according to any one of claims 1 to 3, wherein the adhesion force at the interface between the support film and the transfer layer is from 0.02 to 1.50 MPa.

5. The transfer film according to any one of claims 1 to 4, wherein the surface of the support film, whereon the transfer layer is laminated, is made of a polyolefin-based resin.

6. The transfer film according to any one of claims 1 to 4, wherein the surface of the support film, whereon the transfer layer is laminated, is made of an acrylic resin.

7. The transfer film according to any one of claims 1 to 6, wherein the transfer layer has a hardness of 0.1 to 0.6 GPa.

8. The transfer film according to any one of claims 1 to 7, wherein the surface of the support film, which comes into contact with the transfer layer, has a concave-convex shape.

9. The transfer film according to claim 8, wherein the concave-convex shape has a typical pitch of 0.01 to 10 μm.

10. The transfer film according to claim 8 or 9, wherein the concave-convex shape has an aspect ratio of 0.01 to 3.

11. The transfer film according to any one of claims 1 to 10, wherein the value obtained by dividing the difference in residual film thicknesses, which is given by the difference between the maximum value and the minimum value that are obtained by measuring residual film thickness at ten positions, by the average value of these residual film thicknesses is 25% or less.

Fig. 1

Fig. 2

Fig. 3

(a)

(b)

Fig. 4

Fig. 5

(a)

(b)

## Fig. 6

## Fig. 7

Fig. 8

(a)

8

6

(b)

8

7

6

Fig. 9

(a)

(b)

## INTERNATIONAL SEARCH REPORT

| | International application No. |
|---|---|
| | PCT/JP2012/054223 |

A. CLASSIFICATION OF SUBJECT MATTER
*B32B27/00*(2006.01)i, *B32B27/30*(2006.01)i, *B32B27/32*(2006.01)i

According to International Patent Classification (IPC) or to both national classification and IPC

B. FIELDS SEARCHED

Minimum documentation searched (classification system followed by classification symbols)
B32B1/00-43/00, B44C1/16-1/175, B05D1/00-7/26

Documentation searched other than minimum documentation to the extent that such documents are included in the fields searched
Jitsuyo Shinan Koho          1922-1996   Jitsuyo Shinan Toroku Koho   1996-2012
Kokai Jitsuyo Shinan Koho    1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 10-158594 A (Matsushita Electric Works, Ltd.),<br>16 June 1998 (16.06.1998),<br>claim 1; paragraph [0025]; example 1<br>(Family: none) | 1-8,11<br>9-10 |
| X<br>A | JP 2003-25794 A (Tonen Chemical Corp.),<br>29 January 2003 (29.01.2003),<br>claim 1; paragraphs [0028] to [0030]; example 1<br>(Family: none) | 1-5,7-11<br>6 |
| A | JP 2004-122701 A (Mitsubishi Plastics, Inc.),<br>22 April 2004 (22.04.2004),<br>claim 1; paragraph [0026]; example 1<br>(Family: none) | 1-11 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 May, 2012 (21.05.12) | 29 May, 2012 (29.05.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4079383 B
- JP 3750393 B
- JP 2006154037 A